# EUROPÄISCHE PATENTSCHRIFT

(11) **EP 3 105 650 B1**
(45) Veröffentlichungstag und Bekanntmachung des Hinweises auf die Patenterteilung: **07.08.2019**
(21) Anmeldenummer: 15703026.3
(22) Anmeldetag: 28.01.2015
(51) Int. Cl.: G06F 1/20, H05K 7/20

(54) **KÜHLANORDNUNG FÜR EIN COMPUTERSYSTEM**
COOLING ARRANGEMENT FOR A COMPUTER SYSTEM
CIRCUIT DE REFROIDISSEMENT POUR UN SYSTÈME D'ORDINATEUR

(30) Priorität: 14.02.2014 DE 102014101898
(43) Veröffentlichungstag der Anmeldung: 21.12.2016
(73) Patentinhaber: Fujitsu Client Computing Limited, Kawasaki-shi, Kanagawa-ken 211-8588 (JP)
(72) Erfinder: SCHUBERT, Frank, 86836 Graben (DE)
(74) Vertreter: Epping - Hermann - Fischer
(86) Internationale Anmeldenummer: PCT/EP2015/051731
(87) Internationale Veröffentlichungsnummer: WO 2015/121069

(56) Entgegenhaltungen:
- WO-A1-96/01035
- DE-A1-102010 054 281
- US-A- 5 828 549
- US-A1- 2008 113 607
- US-A1- 2011 013 356
- US-A1- 2012 044 634
- US-A1- 2012 212 906

## Beschreibung

Die Erfindung betrifft eine Kühlanordnung für ein Computersystem, welches eine Hauptplatine mit einer ersten wärmeerzeugenden Komponente und mit einer zweiten wärmeerzeugenden Komponente aufweist.

Computersysteme, insbesondere Desktop-, Tower- oder Workstation-PCs, erzeugen in ihrem Betrieb eine verhältnismäßig große Menge an Wärme, die zum sicheren Betrieb des jeweiligen Computersystems abgeführt werden muss. Eine wesentliche Wärmequelle stellen dabei ein oder mehrere Prozessoren des Computersystems dar. Computersysteme wie Workstation-PCs, welche sich durch hohe Grafik- und Rechnerleistungen auszeichnen, sind zum Bereitstellen dieser Leistung typischerweise mit wenigstens zwei Prozessoren ausgestattet.

Bei derartigen Computersystemen mit zumindest zwei Prozessoren sind diese in der Regel hintereinander angeordnet und werden über je einen Lüfter gekühlt. Nachteilig dabei ist, dass die mittels des ersten Lüfters zum Kühlen angesaugte Kühlluft zunächst durch die Wärme des ersten Prozessors erwärmt wird und anschließend zum Kühlen des zweiten Prozessors verwendet wird. Dadurch, dass die Kühlluft durch den ersten Prozessor erwärmt wird und somit vorgewärmt auf den zweiten Lüfter trifft, steht zum Kühlen des zweiten Prozessors weniger Kühlleistung zur Verfügung. Dies hat zur Folge, dass der zweite Prozessor regelmäßig eine höhere Temperatur im Vergleich zu dem ersten Prozessor aufweist. Eine weitere Folge ist, dass eine Drehzahl des Lüfters zur ausreichenden Kühlung beider Prozessoren vergleichsweise hoch sein muss, wodurch es neben einem hohen Energieverbrauch zudem auch zu einer störenden Geräuschentwicklung kommt.

Aus der DE 10 2010 054 281 A1 ist ein elektronisches Gerät mit einem Gehäuse bekannt. In dem Gehäuse sind eine Wärme erzeugende erste Komponente, eine Wärme erzeugende zweite Komponente sowie ein Kühlsystem angeordnet.

Aus der US 2008/0113607 A1 ist ein Luftleitelement bekannt, welches für ein Computersystem mit einem Lüfter und zwei in Wärme erzeugenden Komponenten, die in Reihe angeordnet sind.

Aus den Offenlegungsschriften US 2012/0212906 A1, US 2011/0013356 A1 und US 2012/0044634 A1 sind Computersysteme mit Kühlungen bekannt.

Eine Aufgabe, welche der Erfindung zugrunde liegt, ist es, eine Kühlanordnung für ein Computersystem zu beschreiben, welche sich durch einen einfachen Aufbau und eine besonders effiziente Kühlung auszeichnet.

Die Aufgabe wird gelöst durch eine Kühlanordnung für ein Computersystem, welches eine Hauptplatine mit einer ersten wärmeerzeugenden Komponente und mit einer zweiten wärmeerzeugenden Komponente aufweist. Weiter weist die Kühlanordnung eine mit der ersten wärmeerzeugenden Komponente thermisch gekoppelte erste Wärmesenke und eine mit der zweiten wärmeerzeugenden Komponente thermisch gekoppelte zweite Wärmesenke auf. Zudem weist die Kühlanordnung einen ersten Lüfter zum Erzeugen eines Luftstroms in Richtung der ersten Wärmesenke auf. Die zweite Wärmesenke ist in Strömungsrichtung des durch den ersten Lüfter erzeugten Luftstroms hinter der ersten Wärmesenke angeordnet. Des Weiteren ist zwischen der ersten Wärmesenke und einer Ausblasöffnung des ersten Lüfters eine Lufthutze angeordnet. Die Lufthutze ist als Hohlkörper mit einer ersten Öffnung und mit einer der ersten Öffnung gegenüberliegenden zweiten Öffnung ausgebildet. Die erste Öffnung ist der Ausblasöffnung des ersten Lüfters und die zweite Öffnung ist der ersten Wärmesenke zugewandt. Eine der ersten Wärmesenke zugewandte Fläche der Ausblasöffnung des ersten Lüfters ist größer als eine der Ausblasöffnung zugewandte und in eine Ebene parallel zu der Ausblasöffnung projizierte Fläche der ersten Wärmesenke. Die Lufthutze weist einen Strömungsquerschnitt auf, welcher einer der Ausblasöffnung zugewandten und in eine Ebene parallel zu der Ausblasöffnung projizierten Fläche der ersten Wärmesenke entspricht. Dadurch wird ein erster Teil des erzeugten Luftstroms über die Lufthutze direkt der ersten Wärmesenke zugeführt und ein zweiter Teil des erzeugten Luftstromes umströmt die Lufthutze und die erste Wärmesenke, wobei der zweite Teil der zweiten Wärmesenke zuströmt.

Die Kühlanordnung ermöglicht einen einfachen Aufbau und eine besonders effektive Kühlung sowohl der ersten wärmeerzeugenden Komponente als auch der zweiten wärmeerzeugenden Komponente. Die beiden wärmeerzeugenden Komponenten, welche beispielsweise Prozessoren des Computersystems sind, weisen jeweils eine Wärmsenke, beispielsweise einen lamellenartigen Kühlkörper, auf. Die beiden Wärmsenken sind hintereinander, also etwa in Reihe, hinter dem ersten Lüfter angeordnet, welcher den Luftstrom in Richtung der ersten Wärmesenke erzeugt. Dabei wird ein Teil des erzeugten Luftstroms des ersten Lüfters über die Lufthutze direkt, also praktisch ausschließlich der ersten Wärmesenke zugeführt, während ein zweiter Teil des erzeugten Luftstroms die Lufthutze und die erste Wärmesenke umströmt, insbesondere seitlich. Dadurch ist es möglich, dass der zweite Teil des erzeugten Luftstroms im Wesentlichen nicht oder nur leicht beim Umströmen der ersten Wärmesenke durch diese oder weitere wärmeerzeugenden Komponenten erwärmt wird. Dieser zweite Teil kann nun der zweiten Wärmesenke, welche hinter der ersten Wärmesenke angeordnet ist, zuströmen und diese besonders effektiv und effizient kühlen. Somit wird die Wärme der zweiten Wärmesenke nicht ausschließlich durch bereits von der ersten Wärmesenke erwärmte Luft gekühlt, wodurch eine Kühlleistung für die zweite Wärmesenke merklich sinken würde. Die Lufthutze ermöglicht somit ein Art Bypass für den zweiten Teil der Luft.

In einer Vielzahl von Experimenten hat sich überraschenderweise gezeigt, dass im Vergleich zu eingangs genannten Computersystemen, bei welchen während des Betriebs zwischen der ersten wärmeerzeugenden Komponente und der zweiten wärmeerzeugenden Komponente ein Temperaturunterschied von mehreren Grad Celsius wie in etwa 8° C besteht, bei der erfindungsgemäßen Lösung die erste wärmeerzeugende Komponente und die zweite wärmeerzeugende Komponente in etwa die gleiche Temperatur aufweisen.

Durch die beschriebene Kühlanordnung kann zudem die Drehzahl des ersten Lüfters verglichen mit eingangs beschriebenen Computersystemen reduziert werden, wobei eine störende Geräuschentwicklung verringert ist und der Energieverbrauch des ersten Lüfters gesenkt wird.

Erfindungsgemäß ist eine der ersten Wärmesenke zugewandte Fläche der Ausblasöffnung des ersten Lüfters größer als eine der Ausblasöffnung zugewandte und in eine Ebene parallel zu der Ausblasöffnung projizierte Fläche der ersten Wärmesenke. Bevorzugt überlappt die Fläche der Ausblasöffnung des ersten Lüfters die der Ausblasöffnung zugewandte und in die Ebene parallel zu der Ausblasöffnung projizierte Fläche der ersten Wärmesenke. Dadurch kann mittels des ersten Lüfters ein Luftstrom erzeugt werden, welcher einen besonders großen Strömungsquerschnitt hat, insbesondere größer als die der Ausblasöffnung des ersten Lüfters zugewandte, projizierte Fläche der ersten Wärmesenke. Damit kann erreicht werden, dass der zweite Teil des erzeugten Luftstroms einen großen Anteil des gesamten erzeugten Luftstroms des ersten Lüfters ausmacht und somit ausreichend Kühlluft der zweiten Wärmesenke zugeführt werden kann. Insbesondere kann der zweite Teil des erzeugten Luftstromes ungehindert an der ersten Wärmesenke, also ohne Verwirbelungen, vorbei strömen.

Bei der Projektion handelt es sich, wie auch im Folgenden, um eine Abbildung von Punkten eines dreidimensionalen Körpers, in diesen Fall der Wärmesenke, in eine gegebene Ebene, wobei die Projektionsstrahlen zueinander parallel sind. Im hier beschriebenen Fall treffen die Projektionsstrahlen im rechten Winkel auf die Projektionsebene, also die Ebene der Ausblasöffnung, wobei es sich um eine Orthogonalprojektion handelt.

Weiterhin ist die Lufthutze als Hohlkörper mit einer ersten Öffnung und mit einer der ersten Öffnung gegenüberliegenden zweiten Öffnung ausgebildet, wobei die erste Öffnung der Ausblasöffnung des ersten Lüfters und die zweite Öffnung der ersten Wärmesenke zugewandt ist. Bevorzugt weist der Hohlkörper einen kontinuierlichen, stetigen Strömungsquerschnitt auf und ist beispielsweise zylinderförmig oder quaderförmig ausgestaltet. Dadurch ist gewährleistet, dass über die erste Öffnung der erste Teil des von dem ersten Lüfter erzeugten Luftstroms direkt und ohne Verwirbelungen der ersten Wärmesenke zugeführt werden kann. Insbesondere kommt es somit zu keinen Druckverlusten innerhalb des Hohlkörpers und somit zu keinem Verlust von Kühlleistung.

Weiterhin weist die Lufthutze einen Strömungsquerschnitt auf, welcher einer der Ausblasöffnung zugewandten und in eine Ebene parallel zu der Ausblasöffnung projizierten Fläche der ersten Wärmesenke entspricht. Dadurch wird erreicht, dass die erste Wärmesenke ausreichend gekühlt wird, wobei insbesondere sichergestellt ist, dass der gesamten Fläche, welche der Ausblasöffnung des ersten Lüfters zugewandt ist, Kühlluft über die Lufthutze zugeführt wird.

In weiteren, vorteilhaften Ausgestaltungen der Erfindung ist die Lufthutze derart an dem ersten Lüfter angeordnet, dass die erste Öffnung an einer die Ausblasöffnung aufweisenden Seite des ersten Lüfters anliegt. Zusätzlich oder alternativ ist die Lufthutze mit der zweiten Öffnung an der ersten Wärmesenke angeordnet oder umgibt mittels der zweiten Öffnung die Wärmesenke zumindest teilweise in Richtung einer Strömungsrichtung des erzeugten Luftstroms des ersten Lüfters.

Dadurch ist es möglich, dass der erste Teil des von dem ersten Lüfter erzeugten Luftstroms direkt über die erste Öffnung der Lufthutze zugeführt werden kann. Indem die Lufthutze mit der zweiten Öffnung an der ersten Wärmesenke angeordnet ist oder diese zumindest teilweise umschließt, kann der erste Teil des erzeugten Luftstroms des ersten Lüfters direkt und vollständig der ersten Wärmesenke zugeführt werden.

Bevorzugt ist ein durch die erste Öffnung begrenzter Strömungsquerschnitt der Lufthutze geringer als die Fläche der Ausblasöffnung des ersten Lüfters. Dadurch wird erreicht, dass der erste Teil des durch den ersten Lüfter erzeugten Luftstroms der Lufthutze zugeführt wird, während der zweite Teil des erzeugten Luftstroms des ersten Lüfters die Lufthutze umströmen kann und somit zum Kühlen der zweiten Wärmesenke beziehungsweise der wärmeerzeugenden Komponente verwendet werden kann.

In einer weiteren, vorteilhaften Ausgestaltung der Erfindung ist in einem Bereich der zweiten Wärmesenke ein zweiter Lüfter angeordnet, welcher einen Luftstrom auf die zweite Wärmesenke erzeugt. Bevorzugt ist der zweite Lüfter zwischen der ersten Wärmesenke und der zweiten Wärmesenke sowie zumindest teilweise innerhalb des von dem ersten Lüfter erzeugten Luftstromes angeordnet. Besonders bevorzugt ist der zweite Lüfter dabei an einer dem ersten Lüfter bzw. der ersten Wärmesenke zugewandten Seite der zweiten Wärmesenke an dieser angeordnet.

Mittels des zweiten Lüfters ist es möglich, die zweite Wärmesenke besonders effektiv zu kühlen, wobei der zweite Lüfter insbesondere den zweiten Teil des von dem ersten Lüfter erzeugten Luftstromes ansaugt. Mittels des zweiten Lüfters wird die Luft des von dem ersten Lüfter erzeugten Luftstromes beschleunigt, sodass eine ausreichende Kühlleistung für die zweite wärmeerzeugende Komponente bereitgestellt wird.

Weitere Ausgestaltungen der Erfindung sind in den Unteransprüchen sowie in der nachfolgenden, ausführlichen Beschreibung eines Ausführungsbeispiels unter Zuhilfenahme der angehängten Figuren beschrieben. Beschriebene Ausführungsarten, die nicht in den Schutzumfang der Ansprüche fallen, sind nicht Teil der beanspruchten Erfindung.

In den Figuren zeigen:
- Figur 1: eine schematische, perspektivische Ansicht eines Computersystems mit einer Kühlanordnung gemäß einem Ausführungsbeispiel der Erfindung,
- Figur 2: eine schematische Rückansicht der Kühlanordnung sowie
- Figur 3: eine schematische Draufsicht der Kühlanordnung.

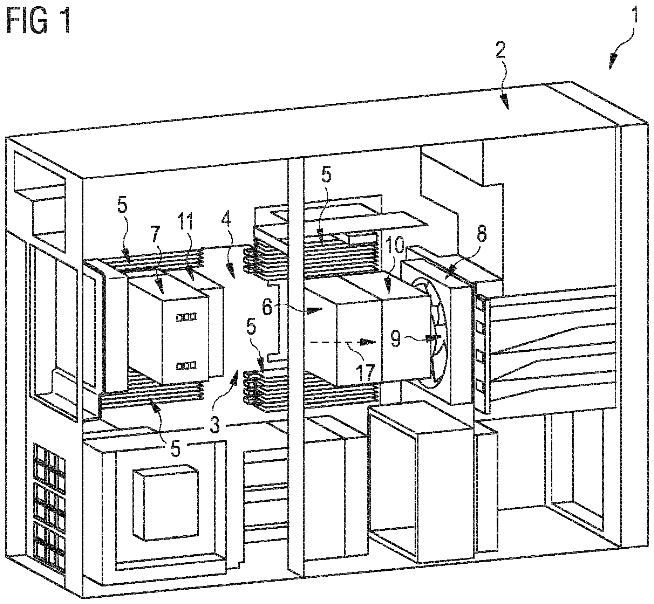

Figur 1 zeigt schematisch eine perspektivische Ansicht eines Computersystems 1, welches ein Gehäuse 2 und eine im Inneren des Gehäuses 2 angeordnete Kühlanordnung 3 aufweist. Im Inneren des Gehäuses 2 ist das Computersystem 1 mit einer Hauptplatine 4 ausgestattet. Auf der Hauptplatine 4 befinden sich zwei nicht dargestellte Prozessoren (CPUs), welche eine erste wärmeerzeugende Komponente und eine zweite wärmeerzeugende Komponente des Computersystems 1 darstellen. Neben den beiden Prozessoren sind auf der Hauptplatine 4 und im Inneren des Gehäuses 2 weitere wärmeerzeugende Komponenten angeordnet, wie beispielsweise Speicherbänke 5.

Insbesondere die beiden Prozessoren erzeugen im Betrieb des Computersystems 1, welches im Ausführungsbeispiel ein Workstation-PC ist, eine hohe Abwärme, die zum sicheren Betrieb des Computersystems 1 abgeführt werden muss, um das Computersystem 1 vor Funktionsstörungen und/oder - beeinträchtigungen zu schützen. Hierzu weist die Kühlanordnung 3 eine auf dem ersten Prozessor angeordnete erste Wärmesenke 6 und eine auf dem zweiten Prozessor angeordnete zweite Wärmesenke 7 auf. Die beiden Wärmesenken 6 und 7 sind als lamellenartige, quaderförmige Kühlkörper ausgestaltet und stehen mit einer Oberfläche in thermischem Kontakt jeweils mit dem entsprechenden Prozessor. Die beiden Wärmesenken 6, 7 sind dabei gleichgroß dimensioniert, wodurch Kosten eingespart werden können durch Verwendung eines gleichen Bauelements. Die beiden Wärmesenken können auch unterschiedlich groß dimensioniert sein. Anstelle der lamellenartigen Kühlkörper können auch andere Ausgestaltungen von Wärmesenken, beispielsweise Heatpipes, vorgesehen sein. In einer weiteren Alternative kann anstelle der thermischen Kopplung mittels einer Oberfläche der beiden Wärmesenken 6 und 7 auch eine thermische Kopplung mit Hilfe einer oder mehrerer Heatpipes bewerkstelligt werden, welche die Wärme von dem Prozessor abführen und einer Wärmesenke 6 oder 7, beispielsweise dem lamellenartigen Kühlkörper, zuführen.

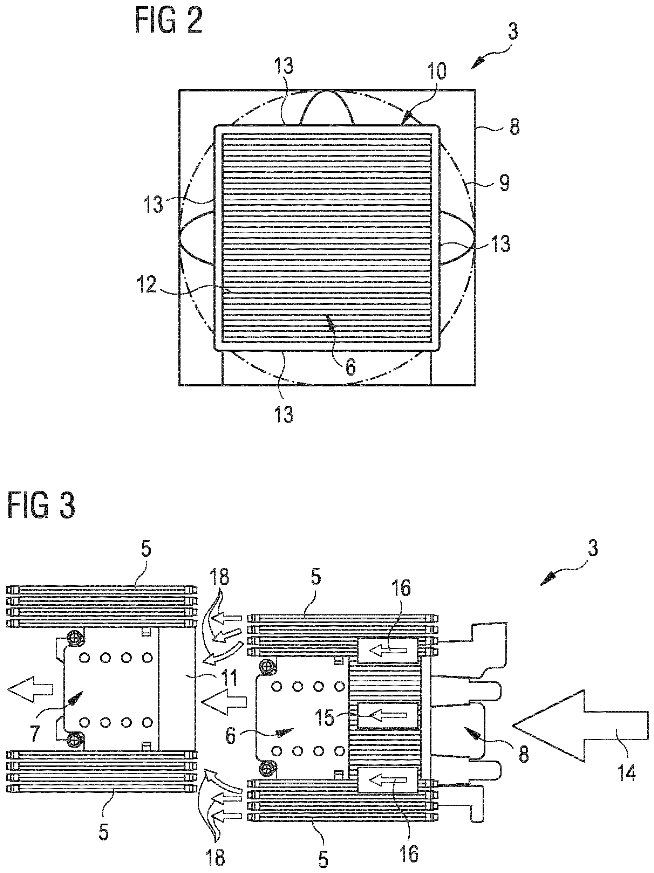

Gegenüber der ersten Wärmesenke 6 ist ein erster Lüfter 8 im Inneren des Gehäuses 2 angeordnet, welcher Frischluft aus einer Umgebung des Gehäuses 2 zum Kühlen der ersten Wärmesenke 6 und der zweiten Wärmesenke 7 ansaugt. An einer der ersten Wärmesenke 6 beziehungsweise dem ersten Lüfter 8 zugewandten Seite der zweiten Wärmesenke 7 ist ein zweiter Lüfter 11 angeordnet. Insgesamt sind somit der erste Lüfter 8, die erste Wärmesenke 6, der zweite Lüfter 11 sowie die zweite Wärmesenke 7 im Wesentlichen in Reihe hintereinander angeordnet und befinden sich in einem gedachten geometrischen, geradlinigen Strömungskanal. Dabei können die beiden Wärmesenken 6 und 7 zentral zueinander, also beispielsweise zentral bezüglich einer Mittellängsachse, oder aber auch leicht versetzt zueinander angeordnet sein, wie in dem Ausführungsbeispiel gemäß Figur 1 gezeigt (siehe auch Figur 3). Die beiden Lüfter 8 und 11 sind als Axiallüfter ausgebildet, wobei sich alternativ auch andere Lüfterausgestaltungen anbieten.

Die Kühlanordnung 3 ist ergänzt durch eine Lufthutze 10, welche zwischen einer Ausblasöffnung 9 des ersten Lüfters 8 und der ersten Wärmesenke 6 angeordnet ist.

Mit Hilfe der Figuren 2 und 3 wird im Folgenden die Kühlanordnung 3 und das Kühlprinzip dieser detailliert beschrieben.

Figur 2 zeigt dabei eine Rückansicht eines Teils der Kühlanordnung 3, ausgehend von der ersten Wärmesenke 6 in Blickrichtung des in Figur 1 gestrichelt dargestellten Pfeiles 17 auf die Lufthutze 10 und den dahinterliegenden ersten Lüfter 8. Figur 3 zeigt eine schematische Seitenansicht der Kühlanordnung 3. Aus Gründen der Übersicht sind eine Vielzahl der Komponenten des Computersystems 1 in den Figuren 2 und 3 nicht dargestellt.

Wie in Figur 2 dargestellt, ist eine Fläche der Ausblasöffnung 9 des ersten Lüfters 8 größer als eine der Ausblasöffnung 9 zugewandte Fläche 12 (gestreift dargestellt) der ersten Wärmesenke 6. Die Fläche 12 entspricht dabei einer dem ersten Lüfter 8 zugewandten und zu der Fläche der Ausblasöffnung 9 parallelen Seite der ersten Wärmesenke 6. Die Fläche 12 kann - wie eingangs erwähnt - auch als eine dem ersten Lüfter 8 zugewandte und in eine Ebene parallel zu der Ausblasöffnung 9 (orthogonal) projizierte Fläche definiert sein. Der erste Lüfter 8 ist bezüglich der ersten Wärmesenke 6 im Wesentlichen zentral angeordnet, wobei die Ausblasöffnung 9 des ersten Lüfters 8 die Fläche 12 der ersten Wärmesenke 6 sowie vier Seitenwände 13 der Lufthutze 10 überlappt. In anderen Worten ausgedrückt erstreckt sich die Ausblasöffnung 9 radial zumindest teilweise über einen größeren Bereich als die in eine Ebene parallel zu der Ausblasöffnung 9 (orthogonal) projizierte erste Wärmesenke 6.

Die Lufthutze 10 ist als Hohlkörper ausgestaltet und weist eine dem ersten Lüfter 8 zugewandte erste Öffnung sowie eine der Wärmesenke 6 zugewandte zweite Öffnung auf. Dabei liegen sich die erste Öffnung und die zweite Öffnung gegenüber. Die Lufthutze 10 ist als geschlossener, quaderförmiger Hohlkörper mit den vier Seitenwänden 13 ausgeführt. Alternativ weist die Lufthutze 10 ein U-förmiges Profil mit drei Seitenwänden 13 auf, wobei beispielsweise auf die in Figur 2 untere Seitenwand 13 verzichtet ist. Die Lufthutze 10 bildet einen Strömungskanal für einen von dem ersten Lüfter erzeugten Luftstrom aus. Für die Lufthutze 10 bieten sich alternative Ausführungsformen, wie beispielsweise eine zylindrische Ausgestaltung, an.

Die Lufthutze 10 ist mit der zweiten Öffnung an der ersten Wärmesenke 6 angeordnet. Alternativ kann die Lufthutze 10 auch mittels der zweiten Öffnung einen Teil der ersten Wärmesenke 6 umgeben.

Wird nun, wie in Figur 3 schematisch dargestellt, mittels des ersten Lüfters Kühlluft gemäß einer ersten Pfeilrichtung 14 von außerhalb des Gehäuses 2 des Computersystems 1 angesaugt, so wird ein erster Teil des erzeugten Luftstroms durch die Lufthutze 10 gemäß einer zweiten Pfeilrichtung 15 direkt der ersten Wärmesenke 6 zugeführt. Dadurch, dass die Ausblasöffnung 9 des ersten Lüfters 8 die Lufthutze 10 wie oben beschrieben zumindest teilweise seitlich überlappt, wird ein zweiter Teil des erzeugten Luftstroms gemäß der Pfeilrichtungen 16 seitlich an der Lufthutze 10 und auch seitlich an der ersten Wärmesenke 6 vorbeigeführt. Die Lufthutze 10 sorgt somit dafür, dass der von dem ersten Lüfter 8 erzeugte Luftstrom teilweise der ersten Wärmesenke 6 direkt zugeführt wird, während der zweite Teil des erzeugten Luftstroms sowohl die Lufthutze 10 als auch die erste Wärmesenke 6 umströmt. Die Lufthutze 10 ermöglicht also eine Art Bypass für den zweiten Teil des von dem ersten Lüfter 8 erzeugten Luftstroms.

Der erste Teil des erzeugten Luftstroms, welcher gemäß der zweiten Pfeilrichtung 15 die erste Wärmesenke 6 durchströmt, wird beim Durchströmen der ersten Wärmesenke 6 leicht abgebremst, da die erste Wärmesenke 6 ein Strömungshindernis bewirkt. Dabei nimmt der erste Teil des erzeugten Luftstroms die von dem Prozessor abgeführte Wärme auf. Der zweite Teil des erzeugten Luftstroms, welcher gemäß der dritten Pfeilrichtungen 16 seitlich die erste Wärmesenke 6 umströmt, strömt der hinter der ersten Wärmesenke 6 angeordneten zweiten Wärmsenke 7 zumindest teilweise gemäß vierten Pfeilrichtungen 18 zu. Da der zweite Teil des erzeugten Luftstroms ungehindert strömt, hat dieser in der Regel eine höhere Geschwindigkeit als der erste Teil. Dabei wird die im Wesentlichen nicht erwärmte Luft des zweiten Teils des erzeugten Luftstroms des ersten Lüfters 8 von dem zweiten Lüfter 11 angesaugt und direkt der zweiten Wärmesenke 7 zugeführt. Neben dem zweiten Teil des erzeugten Luftstroms des ersten Lüfters 8 wird die durch die erste Wärmesenke 6 erwärmte Luft des ersten Teils des erzeugten Luftstroms des ersten Lüfters 8 ebenfalls von dem zweiten Lüfter 11 angesaugt, wobei bei entsprechender Drehzahleinstellung des zweiten Lüfters 11 die zweite Wärmsenke 7 besonders effizient gekühlt werden kann.

Mittels der Kühlanordnung 3 wird erreicht, dass die beiden Prozessoren im Wesentlichen eine gleiche Temperatur im Betrieb aufweisen. Zudem können die Lüfterdrehzahlen des ersten Lüfters 8 beziehungsweise des zweiten Lüfters 11 derart eingestellt werden, sodass es zu keinem besonders störenden Geräuschentwicklungen beziehungsweise -emissionen kommt.

Im Ausführungsbeispiel gemäß der Figuren 1 bis 3 ist der zweite Lüfter 11 kleiner dimensioniert als der erste Lüfter 8. Dabei ist eine Ausblasöffnung des zweiten Lüfters 11 kleiner aus die Ausblasöffnung 9 des ersten Lüfters 8. Dadurch, dass der zweite Teil des von dem ersten Lüfter 8 erzeugten Luftstroms im Wesentlichen eine Temperatur aufweist, die der Umgebungstemperatur des Computersystems 1 entspricht, kann der zweite Lüfter 11 derart kleiner als der erste Lüfter 8 dimensioniert sein, da zum effektiven Kühlen der zweiten Wärmesenke 7 eine ausreichende Kühlleistung durch den zweiten Lüfter 11 bereitgestellt werden kann.

Im Ausführungsbeispiel weist die Lufthutze 10 aufgrund der quaderförmigen Ausgestaltung einen konstanten Strömungsquerschnitt auf, welcher im Wesentlichen der dem ersten Lüfter 8 zugewandten Seite der ersten Wärmesenke 6 entspricht. Alternativ kann der Strömungsquerschnitt auch kleiner oder größer als die im ersten Lüfter 8 zugewandte Fläche der ersten Wärmesenke 6 sein. Zusätzlich oder alternativ kann sich der Strömungsquerschnitt der Lufthutze 10 in Strömungsrichtung des erzeugten Luftstroms des ersten Lüfters 8 auch verändern, beispielsweise kleiner oder größer werden.

Die Lufthutze 10 ist mit ihren beiden Öffnungen sowohl direkt an der Ausblasöffnung 9 des ersten Lüfters 8 sowie an der ersten Wärmesenke 6 angeordnet. In alternativen Ausführungsformen ist die erste Öffnung beabstandet von der Ausblasöffnung 9 des ersten Lüfters 8 angeordnet. In einer weiteren alternativen Ausgestaltungsform ist die zweite Öffnung der Lufthutze 10 beabstandet von der ersten Wärmesenke 6 angeordnet.

In einer weiteren alternativen nicht dargestellten Ausführungsform ist auf den zweiten Lüfter 11 verzichtet, wobei der erste Lüfter 8 eine ausreichende Kühlleistung bereitstellt, wobei insbesondere der zweite Teil des erzeugten Luftstroms ausreicht, die zweite Wärmesenke 7 zu kühlen.

Im Ausführungsbeispiel sind neben den Wärmesenken 6 und 7 seitlich die Speicherbänke 5 angeordnet. Die Speicherbänke 5 werden im Ausführungsbeispiel durch den zweiten Teil des von dem ersten Lüfter 8 erzeugten Luftstroms mitgekühlt. Verglichen zu den Prozessoren erzeugen die Speicherbänke eine deutlich geringere Abwärme, sodass diese leicht von dem zweiten Teil des erzeugten Luftstroms des ersten Lüfters aufgenommen werden kann, ohne die Temperatur des zweiten Teils merklich anzuheben. Dadurch ist gewährleistet, dass die Wärme der zweiten Wärmesenke 7 effizient abgeführt werden kann.

In dem Ausführungsbeispiel umströmt der zweite Teil des erzeugten Luftstroms des ersten Lüfters im Wesentlichen die Lufthutze 10 an allen Seiten 13. Alternativ ist die erste Wärmesenke 6 und/oder die Lufthutze 10 selbst bezüglich des ersten Lüfters 8 derart angeordnet, dass beispielsweise nur eine Seitenwand 13 oder zwei Seitenwände 13 der Lufthutze 10 und/oder der ersten Wärmesenke 6 von dem zweiten Teil des erzeugten Luftstroms des ersten Lüfters umströmt werden. Auch dabei ergeben sich die vorgenannten Vorteile und die effiziente Kühlung der zweiten Wärmesenke 7.

### Bezugszeichenliste

- 1: Computersystem
- 2: Gehäuse
- 3: Kühlanordnung
- 4: Hauptplatine
- 5: Speicherbänke
- 6: erste Wärmesenke
- 7: zweite Wärmesenke
- 8: erster Lüfter
- 9: Ausblasöffnung
- 10: Lufthutze
- 11: zweiter Lüfter
- 12: Fläche
- 13: Seitenwand
- 14: erste Pfeilrichtung
- 15: zweite Pfeilrichtung
- 16: dritte Pfeilrichtung
- 17: Pfeil
- 18: vierte Pfeilrichtung

## Patentansprüche

1. Kühlanordnung (3) für ein Computersystem (1), aufweisend
- eine Hauptplatine (4) mit einer ersten wärmeerzeugenden Komponente und einer zweiten wärmeerzeugenden Komponente;
- eine mit der ersten wärmeerzeugenden Komponente thermische gekoppelte erste Wärmesenke (6) und eine mit der zweiten wärmeerzeugenden Komponente thermisch gekoppelte zweite Wärmesenke (7);
- einen ersten Lüfter (8) zum Erzeugen eines Luftstroms in Richtung der ersten Wärmesenke (6), wobei die zweite Wärmsenke (7) in Strömungsrichtung des durch den ersten Lüfter (8) erzeugten Luftstroms hinter der ersten Wärmesenke (6) angeordnet ist; und
- eine zwischen der ersten Wärmesenke (6) und einer Ausblasöffnung (9) des ersten Lüfters (8) angeordnete Lufthutze (10), wobei
- die Lufthutze (10) als Hohlkörper mit einer ersten Öffnung und mit einer der ersten Öffnung gegenüberliegenden zweiten Öffnung ausgebildet ist,
- die erste Öffnung der Ausblasöffnung (9) des ersten Lüfters (8) und die zweite Öffnung der ersten Wärmesenke (6) zugewandt ist,
- eine der ersten Wärmesenke (6) zugewandte Fläche der Ausblasöffnung (9) des ersten Lüfters (8) größer ist als eine der Ausblasöffnung (9) zugewandte und in eine Ebene parallel zu der Ausblasöffnung (9) projizierte Fläche der ersten Wärmesenke (6), und
- die Lufthutze (10) einen Strömungsquerschnitt aufweist, welcher einer der Ausblasöffnung (9) zugewandten und in eine Ebene parallel zu der Ausblasöffnung (9) projizierten Fläche der ersten Wärmesenke (6) entspricht,
so dass ein erster Teil des erzeugten Luftstroms über die Lufthutze (10) direkt der ersten Wärmesenke (6) zugeführt wird und ein zweiter Teil des erzeugten Luftstroms die Lufthutze (10) sowie die erste Wärmesenke (6) umströmt, wobei der zweite Teil der zweiten Wärmesenke (7) zuströmt.

2. Kühlanordnung (3) nach einem der vorhergehenden Ansprüche,
wobei eine Fläche der Ausblasöffnung (9) eine der Ausblasöffnung (9) zugewandte und in eine Ebene parallel zu der Ausblasöffnung (9) projizierte Fläche der ersten Wärmesenke (6) überlappt.

3. Kühlanordnung (3) nach einem der Ansprüche 1 bis 2,
wobei die Lufthutze (10) derart an dem ersten Lüfter (8) angeordnet ist, dass die erste Öffnung an einer die Ausblasöffnung aufweisenden Seite des ersten Lüfters (8) angeordnet ist.

4. Kühlanordnung (3) nach einem der Ansprüche 1 bis 3,
wobei die Lufthutze (10) mit der zweiten Öffnung an der ersten Wärmesenke (6) angeordnet ist oder mittels der zweiten Öffnung die erste Wärmesenke (6) zumindest teilweise in Richtung einer Strömungsrichtung des erzeugten Luftstromes des ersten Lüfters (8) umschließt.

5. Kühlanordnung (3) nach einem der vorhergehenden Ansprüche,
wobei ein durch die erste Öffnung begrenzter Strömungsquerschnitt der Lufthutze (10) kleiner ist als eine Fläche der Ausblasöffnung (9) des ersten Lüfters (8) .

6. Kühlanordnung (3) nach einem der vorhergehenden Ansprüche,
wobei in einem Bereich der zweiten Wärmesenke (7) ein zweiter Lüfter (11) angeordnet ist, welcher einen Luftstrom auf die zweite Wärmesenke (7) erzeugt.

7. Kühlanordnung (3) nach einem der vorhergehenden Ansprüche,
wobei die erste Wärmesenke (6) und/oder die zweite Wärmesenke (7) als Kühlkörper mit Lamellen ausgebildet sind.

## Claims

1. Cooling arrangement (3) for a computer system (1), comprising
- a mainboard (4) with a first heat-generating component and a second heat-generating component;
- a first heat sink (6) thermally coupled with the first heat-generating component, and a second heat sink (7) thermally coupled with the second heat-generating component;
- a first fan (8) for generating an air flow in the direction towards the first heat sink (6), wherein the second heat sink (7) is arranged behind the first heat sink (6) in the direction of flow of the air flow generated by the first fan (8); and
- an air scoop (10) arranged between the first heat sink (6) and a blow-out opening (9) of the first fan (8), wherein
- the air scoop (10) is in the form of a hollow body having a first opening and having a second opening opposite the first opening,
- the first opening faces the blow-out opening (9) of the first fan (8) and the second opening faces the first heat sink (6),
- an area of the blow-out opening (9) of the first fan (8) facing the first heat sink (6) is larger than an area of the first heat sink (6) facing the blow-out opening (9) and projected into a plane parallel to the blow-out opening (9), and
- the air scoop (10) has a flow cross-section which corresponds to an area of the first heat sink (6) facing the blow-out opening (9) and projected into a plane parallel to the blow-out opening (9),
so that a first portion of the generated air flow is guided *via* the air scoop (10) directly to the first heat sink (6) and a second portion of the generated air flow flows around the air scoop (10) and the first heat sink (6), wherein the second portion flows to the second heat sink (7).

2. Cooling arrangement (3) according to any one of the preceding claims,
wherein an area of the blow-out opening (9) overlaps an area of the first heat sink (6) facing the blow-out opening (9) and projected into a plane parallel to the blow-out opening (9).

3. Cooling arrangement (3) according to either claim 1 or claim 2,
wherein the air scoop (10) is arranged at the first fan (8) such that the first opening is arranged on a side of the first fan (8) that comprises the blow-out opening.

4. Cooling arrangement (3) according to any one of claims 1 to 3,
wherein the air scoop (10) is arranged with the second opening at the first heat sink (6) or, by means of the second opening, surrounds the first heat sink (6) at least in part in the direction of a direction of flow of the generated air flow of the first fan (8).

5. Cooling arrangement (3) according to any one of the preceding claims,
wherein a flow cross-section of the air scoop (10) delimited by the first opening is smaller than an area of the blow-out opening (9) of the first fan (8).

6. Cooling arrangement (3) according to any one of the preceding claims,
wherein in a region of the second heat sink (7) there is arranged a second fan (11) which generates an air flow towards the second heat sink (7).

7. Cooling arrangement (3) according to any one of the preceding claims,
wherein the first heat sink (6) and/or the second heat sink (7) are in the form of cooling bodies with fins.

## Revendications

1. Ensemble de refroidissement (3) pour un système informatique (1), présentant
- une carte mère (4) avec un premier composant produisant de la chaleur et un deuxième composant produisant de la chaleur;
- un premier dissipateur thermique (6) couplé thermiquement au premier composant produisant de la chaleur et un deuxième dissipateur thermique (7) couplé thermiquement au deuxième composant produisant de la chaleur ;
- un premier ventilateur (8) servant à produire un flux d'air en direction du premier dissipateur thermique (6), dans lequel le deuxième dissipateur thermique (7) est disposé dans la direction d'écoulement du flux d'air produit par le premier ventilateur (8) derrière le premier dissipateur thermique (6) ; et
- une prise d'air (10) disposée entre le premier dissipateur thermique (6) et une ouverture d'évacuation par soufflage (9) du premier ventilateur (8), dans lequel
- la prise d'air (10) est réalisée sous la forme d'un corps creux avec une première ouverture et avec une deuxième ouverture faisant face à la première ouverture,
- la première ouverture est tournée vers l'ouverture d'évacuation par soufflage (9) du premier ventilateur (8) et la deuxième ouverture est tournée vers le premier dissipateur thermique (6),
- une surface, tournée vers le premier dissipateur thermique (6), de l'ouverture d'évacuation par soufflage (9) du premier ventilateur (8) est plus grande qu'une surface, tournée vers l'ouverture d'évacuation par soufflage (9) et projetée dans un plan de manière parallèle par rapport à l'ouverture d'évacuation par soufflage (9), du premier dissipateur thermique (6), et
- la prise d'air (10) présente une section transversale d'écoulement, laquelle correspond à une surface, tournée vers l'ouverture d'évacuation par soufflage (9) et projetée dans un plan de manière parallèle par rapport à l'ouverture d'évacuation par soufflage (9), du premier dissipateur thermique (6),
de sorte qu'une première partie du flux d'air produit est amenée par l'intermédiaire de la prise d'air (10) directement au premier dissipateur thermique (6) et une deuxième partie du flux d'air produit s'écoule autour la prise d'air (10) ainsi que le premier dissipateur thermique (6), dans lequel la deuxième partie s'écoule vers le deuxième dissipateur thermique (7).

2. Ensemble de refroidissement (3) selon l'une quelconque des revendications précédentes,
dans lequel une surface de l'ouverture d'évacuation par soufflage (9) chevauche une surface, tournée vers l'ouverture d'évacuation par soufflage (9) et projetée dans un plan de manière parallèle par rapport à l'ouverture d'évacuation par soufflage (9), du premier dissipateur thermique (6).

3. Ensemble de refroidissement (3) selon l'une quelconque des revendications 1 à 2, dans lequel la prise d'air (10) est disposée de telle manière au niveau du premier ventilateur (8) que la première ouverture est disposée au niveau d'un côté présentant l'ouverture d'évacuation par soufflage, du premier ventilateur (8).

4. Ensemble de refroidissement (3) selon l'une quelconque des revendications 1 à 3, dans lequel la prise d'air (10) est disposée par la deuxième ouverture au niveau du premier dissipateur thermique (6) ou entoure au moyen de la deuxième ouverture le premier dissipateur thermique (6) au moins en partie en direction d'une direction d'écoulement du flux d'air produit du premier ventilateur (8).

5. Ensemble de refroidissement (3) selon l'une quelconque des revendications précédentes,
dans lequel une section transversale d'écoulement, délimitée par la première ouverture, de la prise d'air (10) est plus petite qu'une superficie de l'ouverture d'évacuation par soufflage (9) du premier ventilateur (8) .

6. Ensemble de refroidissement (3) selon l'une quelconque des revendications précédentes,
dans lequel est disposé, dans une zone du deuxième dissipateur thermique (7), un deuxième ventilateur (11), lequel produit un flux d'air vers le deuxième dissipateur thermique (7).

7. Ensemble de refroidissement (3) selon l'une quelconque des revendications précédentes,
dans lequel le premier dissipateur thermique (6) et/ou le deuxième dissipateur thermique (7) sont réalisés sous la forme de corps de refroidissement avec des lamelles.
